# FASCICULE DE BREVET EUROPEEN

(11) **EP 1 926 148 B1**
(45) Date de publication et mention de la délivrance du brevet: **19.08.2009**
(21) Numéro de dépôt: 07118317.2
(22) Date de dépôt: 26.04.2002
(51) Int. Cl.: H01L 31/02, H01L 31/0203, B60S 1/08

(54) **Procédé de fabrication pour un capteur d'image**
Verfahren zur Herstellung eines Lichtsensors
Method of producing a light sensor

(30) Priorité: 27.04.2001 FR 0105672
(43) Date de publication de la demande: 28.05.2008
(62) Demande divisionnaire de: 02727590.8
(73) Titulaire: Security Vision Concept, 1143 Luxembourg (LU)
(72) Inventeur: Albert, Pascal, 8077, Bertrange (LU)
(74) Mandataire: Machtalère, Georges

(56) Documents cités:
- EP-A- 0 941 900
- DE-A- 3 937 605
- US-A- 4 347 436
- PATENT ABSTRACTS OF JAPAN vol. 1999, no. 13, 30 novembre 1999 (1999-11-30) -& JP 11 224975 A (MITSUTOYO CORP), 17 août 1999 (1999-08-17)

## Description

La présente invention concerne un nouveau procédé de fabrication d'un capteur de luminosité destiné à être connecté à un module de traitement du signal pour assurer la commande automatique du fonctionnement d'un appareillage, par exemple, mais non exclusivement, pour déclencher automatiquement l'éclairage d'un véhicule automobile (veilleuses, feux de croisement, éclairage du tableau de bord ...) en fonction des besoins ; elle concerne également le procédé de fabrication de ce capteur.

On connaît déjà de tels capteurs de luminosité utilisés notamment pour commander automatiquement l'éclairage d'un véhicule automobile dès que la luminosité passe en dessous d'un seuil prédéterminé. Ces capteurs intègrent une ou plusieurs photopiles convenablement agencée(s) à l'intérieur de l'habitactle du véhicule et reliée(s) électriquement à un module de traitement du signal pour assurer la commande automatique requise.

Mais les capteurs actuels ne présentent pas toujours une résistance et une tenue optimales, notamment parce que la ou les photopiles utilisées ne sont pas correctement protégées contre les agressions extérieures ou contre les vibrations.

D'autre part, ces capteurs ne sont généralement pas faciles à positionner et à fixer sur leur support de réception.

Un exemple de capteur de luminosité de ce type et son procédé de fabrication est décrit dans le document EP-A-0 522 746.

Le document JP-A-11224975 décrit un dispositif optique avec un capteur de luminosité.

Le document US-A-4 347 436 décrit un procédé de fabrication d'un capteur de luminosité selon le préambule de la revendication 1. En particulier, ce document montre un procédé de fabrication d'un capteur de luminosité dans lequel la face inférieure de la ou des photopile(s) est fixée sur la face supérieure d'un support plan qui est dimensionné pour déborder sur toute la péripherie de ladite photopile. Les deux sorties polarisées aménagées sur la face inférieure de la photopile viennent chacune en contact avec l'une des extrémités de deux pistes conductrices aménagées sur la face supérieure dudit support plan, les deux autres extrémités desdites pistes conductrices s'étendant jusqu'à la bordure périphérique de ce support plan ou sensiblement jusqu'à cette bordure périphérique.

La présente invention vise à remédier aux inconvénients mentionnés ci-dessus en proposant un nouveau procédé de fabrication d'un capteur de luminosité de structure simple, très résistant et très facile à fixer sur de nombreux types et de nombreuses formes de supports de réception. En particulier, l'objectif de l'invention est de fournir un procédé de fabrication d'un capteur de luminosité qui présente une résistance et une tenue optimales dans lequel la ou les photopiles utilisées sont correctement protégées contre les agressions extérieures ou contre les vibrations.

Ces buts ainsi que d'autres sont atteints, suivant l'invention, par un nouveau procédé de fabrication d'un capteur de luminosité ayant les caractéristiques de la partie caractérisante de la revendication 1. Selon l'invention, une couche plane de protection est fixée sur ledit support plan, côté photopile, à l'exception de la zone de positionnement de ladite photopile, et à l'exception de la ou des zones dudit support plan au niveau de laquelle ou desquelles aboutissement les extrémités desdites pistes conductrices, et la couche plane de protection est aménagée pour venir recouvrir les pistes conductrices sur une zone de recouvrement, à l'exception des extrémités des pistes conductrices.

Le support plan de la couche plane de protection qui est associée assurent un cloisonnement et une protection efficace de la photopile, conférant à l'ensemble du capteur de grandes qualités de fiabilité et de longévité.

Toujours selon l'invention, la couche plane de protection associée au support plan a une épaisseur qui est identique ou qui est légèrement supérieure à l'épaisseur de la photopile, et sa surface supérieure comporte un revêtement adhésif qui permet la fixation du capteur sur un support de réception transparent, par exemple sur le pare-brise ou l'une des vitres d'un véhicule.
La surface inférieure de cette couche plane de protection peut également comporter un revêtement adhésif permettant de faciliter sa fixation sur le support plan du capteur.

En fonction de l'application envisagée, la face inférieure du support plan peut aussi comporter un revêtement adhésif permettant la fixation du capteur sur un support de réception quelconque.

Dans un mode de réalisation particulier, le support plan et la couche plane de protection du capteur sont réalisés en matériau souple, en particulier pour permettre la fixation du capteur sur une grande majorité de supports de réception, même non plans. Dans un autre mode de réalisation, le support plan est réalisé en matériau rigide du genre matière plastique ou résine, et la couche plane de protection du capteur est réalisée en matériau souple (par exemple en mousse synthétique).

Selon une autre caractéristique, les pistes conductrices aménagées sur le support plan du capteur aboutissent à proximité les unes des autres, au niveau de la bordure périphérique dudit support plan, pour constituer une zone de connectique.

Selon encore une autre particularité, les pistes conductrices aménagées sur le support plan sont séparées de la couche plane protectrice par un produit isolant.

L'invention concerne également le procédé de fabrication de ce capteur de luminosité consistant :
- à aménager les pistes conductrices sur la surface supérieure du support plan,
- à fixer la ou les photopile(s) sur ledit support plan, ses ou leurs sorties polarisées étant positionnées en contact superposé avec l'une des extrémités desdites pistes conductrices, puis
- à fixer la couche plane protectrice sur ledit support plan. De préférence, on dépose un produit protecteur isolant sur les pistes conductrices du support plan, entre leurs deux extrémités, avant de fixer la ou les photopiles, puis la couche plane de protection.

Mais l'invention sera encore illustrée, sans être aucunement limitée, par la description suivante d'un mode de réalisation particulier, donné uniquement à titre d'exemple et représenté sur les dessins annexés dans lesquels:
- la figure 1 montre un capteur de luminosité conforme à la présente invention, à une échelle agrandie, vu par dessus ;
- la figure 2 est une vue en coupe de ce capteur, selon 2-2 de la figure 1 ;
- la figure 3 est une vue de côté du support plan du capteur de luminosité des figures 1 et 2, isolé ;
- la figure 4 montre le support plan de la figure 3, vu de dessus ;
- la figure 5 montre le support plan des figures 3 et 4 sur la face supérieure duquel ont été aménagées les deux pistes conductrices ;
- les figures 6, 7 et 8 sont des vues respectivement de dessus, de côté et de dessous de la photopile intégrée dans le capteur des figures 1 et 2 ;
- la figure 9 montre la photopile des figures 6 à 8 positionnée sur le support plan de la figure 5 ;
- les figures 10 et 11 sont des vues respectivement de dessus et de côté de la couche plane protectrice destinée à venir recouvrir partiellement le support plan du capteur.

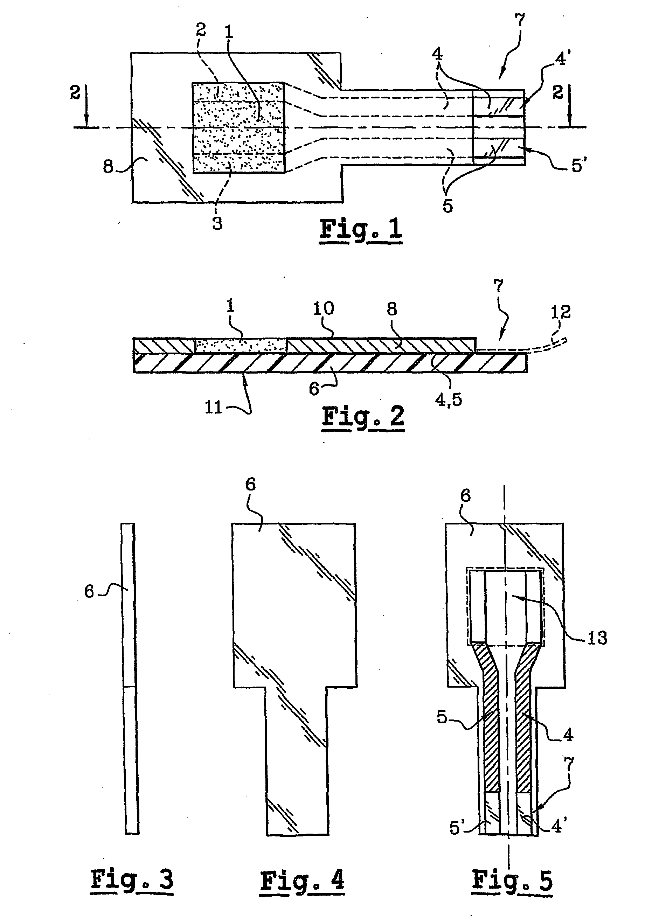

Tel qu'illustré sur les figures 1 et 2, le capteur de luminosité est constitué d'une photopile 1 dont les sorties polarisées 2 et 3 sont chacune en contact avec l'une des extrémités de deux pistes conductrices 4, 5 aménagées sur un support plan 6.

La surface du support plan 6 est supérieure à celle de la section horizontale de la photopile 1, et ladite photopile 1 est positionnée de sorte que ledit support plan 6 déborde sur toute sa périphérie.

Les deux pistes conductrices 4 et 5 s'étendent depuis la zone de positionnement de la photopile 1 jusqu'à la bordure périphérique du support plan 6 au niveau de laquelle leurs extrémités 4' et 5' sont placées à proximité l'une de l'autre pour constituer une zone de connectique 7.

Une couche plane de protection 8 vient recouvrir le support plan 6, côté photopile 1, à l'exception de la zone de positionnement de ladite photopile, et à l'exception de la zone de connectique 7, c'est-à-dire de la zone dudit support plan 6 au niveau de laquelle aboutissent les extrémités 4' et 5' des pistes conductrices 4 et 5.

Cette couche plane de protection 8 ceinture complètement la photopile 1 ; son épaisseur correspond, ou est légèrement supérieure, à l'épaisseur de ladite photopile 1.

La face supérieure de la couche plane de protection 8 comporte un revêtement adhésif 10 pour assurer la fixation du capteur sur un support transparent quelconque, genre vitre ou pare-brise notamment.

La photopile 1 est ainsi protégée de tous les côtés : par le support plan 6, par la couche plane protectrice 8 et par la vitre ou le pare-brise transparent servant de support de réception. Elle est cloisonnée de manière étanche et peut résister de manière convenable aux vibrations auxquelles elle peut être soumise, en fonction de l'application envisagée (ces vibrations, souvent importantes dans les véhicules automobiles en particulier, peuvent s'avérer néfastes aux connexions soudées du capteur).

En fonction des besoins et des applications, la face inférieure 11 du support plan 6 peut aussi comporter un revêtement adhésif de fixation.

Le ou les revêtements adhésifs du capteur sont de préférence protégés par un film jetable en papier ou en matière plastique, destiné à être enlevé juste avant la pose du capteur sur son support de réception.

Les extrémités non recouvertes 4' et 5' des pistes conductrices 4 et 5, correspondant à la zone de connectique 7, permettent la réception de câbles 12 soudés ou sertis, illustrés en pointillés sur la figure 2, pour assurer la continuité électrique et envoyer les informations de luminosité à un module approprié de traitement du signal (non représenté).
Ces extrémités de pistes 4' et 5' peuvent aussi recevoir un connecteur spécifique approprié.

Le support plan 6 ainsi que la couche protectrice 8 peuvent être réalisés en matériau souple pour permettre la fixation du capteur sur tout type de support de réception, et en particulier sur des supports de réception non plans. Les pistes conductrices 4 et 5 sont réalisées et structurées en conséquence.
Dans un autre mode de réalisation possible le support plan 6 est réalisé en matériau rigide (genre matière plastique ou résine), et la couche plane de protection 8 est réalisée en matériau souple.

Les figures 3 à 11 montrent les différents éléments constitutifs de ce capteur, et les différentes étapes de sa fabrication.

Les figures 3 et 4 sont des vues respectivement de côté et de dessus du support plan 6. Ce support plan 6 a ici la forme générale d'un Té, mais il peut prendre n'importe quelle forme (circulaire, carrée, triangulaire ou autre ...). Sa plus grande longueur peut être de l'ordre de 30 mm, sa plus grande largeur de l'ordre de 12 mm et son épaisseur de l'ordre de 2/10^{ème} de mm. Il peut être réalisé en matière plastique souple ou semi-rigide, genre Ultem (Nom déposé) par exemple; comme on l'a indiqué précédemment, il peut aussi être prévu en matière plastique ou en résine rigide.

Tel qu'illustré sur la figure 5, les pistes conductrices 4 et 5 sont conformées sur la face supérieure du support plan 6. Ces pistes conductrices peuvent être réalisées en cuivre, au moyen des techniques classiques de préparation des circuits imprimés ; elles peuvent aussi être réalisées au moyen d'une encre conductrice déposée notamment par une technique de tampographie ou de sérigraphie.
L'épaisseur des pistes conductrices 4 et 5 peut être de l'ordre de 15 à 20 µm.

Entre leurs deux extrémités, c'est-à-dire entre la zone de connectique 7 et la zone 13 de positionnement de la photopile 1, les deux pistes conductrices 4 et 5 reçoivent un dépôt de produit protecteur et isolant, type vernis « épargne » par exemple, de quelques µm d'épaisseur. Cette zone de réception du produit protecteur et isolant correspond à la zone de recouvrement des pistes 4 et 5 par la couche plane protectrice 8 ; elle correspond aux parties hachurées de la figure 5.

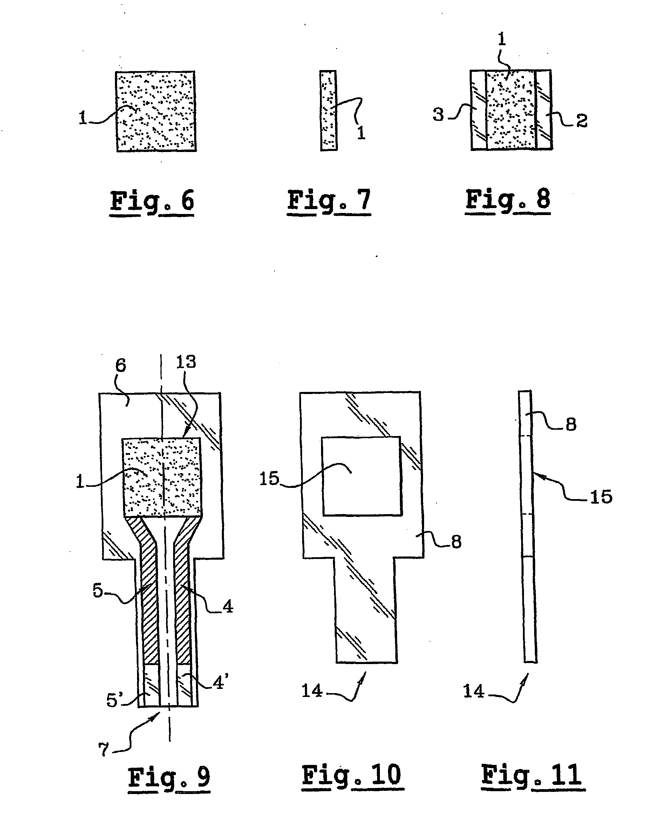

La photopile 1 est représentée isolément sur les figures 6, 7 et 8, respectivement vue par dessus, vue de côté et vue par dessous.

Il s'agit d'une photodiode de type inox ou verre, ayant une forme générale carrée de l'ordre de 5 à 7 mm de côté, et dont l'épaisseur peut être comprise entre 1/10^{ème} et 5/10^{ème} de mm, selon les modèles (ces dimensions ne sont bien entendu pas limitatives). On peut par exemple utiliser une photodiode fabriquée par la Société SOLEMS, PALAISEAU, France.

La face supérieure de la photodiode 1 constitue la face de détection de luminosité (figure 6) ; sur sa face inférieure (figure 8), on remarque les deux sorties polarisées 2 et 3. L'emplacement et la dimension des extrémités des pistes conductrices 4 et 5 qui sont situées au niveau de l'emplacement 13 de la photopile 1 sont adaptés à ces deux sorties polarisées 2 et 3.

La photopile 1 est positionnée et fixée sur l'emplacement 13 du support plan 6 (figure 9), de manière à ce que les deux sorties polarisées 2 et 3 soient en contact superposé avec les extrémités correspondantes des pistes conductrices 4 et 5 (non recouvertes de vernis isolant).
La solidarisation de la photopile 1 avec le support plan 6 est réalisée au moyen d'une colle conductrice, au moyen d'un adhésif conducteur, par une technique de thermosoudage, ou autre...

La couche plane protectrice 8 est représentée isolément sur les figures 10 et 11, respectivement vue par dessus et de côté.
Cette plaque 8 a une forme générale identique à la forme générale du support plan 6, mais elle comporte une troncature 14 au niveau de la zone de connectique 7 du capteur, et une découpe interne 15 au niveau de la zone de positionnement de la photopile 1. Cette découpe 15 correspond à la section horizontale de la photopile.

La plaque protectrice 8 est de préférence réalisée en mousse synthétique type Néoprène (Nom déposé) par exemple. Comme on l'a signalé auparavant, son épaisseur correspond à l'épaisseur de la photopile 1, ou est très légèrement supérieure à l'épaisseur de ladite photopile.

Les faces supérieure et inférieure de la plaque protectrice 8 sont revêtues d'un matériau adhésif, d'une part pour la fixation de cette plaque 8 sur le support 6, et d'autre part, comme précisé ci-avant, pour la fixation du capteur sur un support de réception transparent, type vitre ou pare-brise en particulier.

Selon une variante de réalisation possible, les pistes conductrices du capteur conforme à la présente invention peuvent être réalisées par la dépose d'un adhésif conducteur polarisé (X-Y) double face, sur le support plan 6. Cet adhésif conducteur polarisé permet, une fois la photopile 1 mise en place, d'obtenir les pistes conductrices désirées. La couche plane protectrice 8 est positionnée sur cet adhésif conducteur double face d'une manière similaire à celle décrite ci-avant. La continuité électrique au niveau de la zone de connectique peut alors être réalisée par de simples contacts pressions.

Pour certaines applications particulières, plusieurs photopiles 1 peuvent être associées sur le même support plan 6 ; également, plusieurs doubles sorties polarisées peuvent être envisagées, aboutissant sur la bordure périphérique du support plan 6, à partir de la ou des photopiles 1.

Le modèle particulier de capteur décrit ci-dessus est très simple à réaliser. Sa structure souple autorise de nombreuses possibilités d'implantation et de positionnement. La photopile intégrée 1 est très efficacement protégée et l'ensemble miniaturisé permet un gain de place appréciable.

## Revendications

1. Procédé de fabrication d'un capteur de luminosité comprenant au moins une photopile (1) dont la face supérieure constitue de la face de détection de luminosité et dont la face inférieure comporte deux sorties polarisées (2, 3) destinées à être connectées à un module de traitement du signal pour la commande automatique du fonctionnement d'un appareillage, le procédé consistant à :
- aménager les pistes conductrices (4, 5) sur la surface supérieure du support plan (6),
- fixer la face inférieure de ladite au moins une photopile (1) sur la face supérieure d'un support plan (6) qui est dimensionné pour déborder sur toute la périphérie de ladite au moins une photopile (1), ses ou leurs sorties polarisées (2, 3) étant positionnées en contact superposé avec l'une des extrémités desdites pistes conductrices (4, 5),
les deux autres extrémités (4', 5') desdites pistes conductrices (4, 5) s'étendant jusqu'à la bordure périphérique dudit support plan (6), ou sensiblement jusqu'à cette bordure périphérique,
**caractérisé en ce que** le procédé consiste à fixer une couche plane de protection (8) sur ledit support plan (6), côté photopile (1), à l'exception de la zone (13) de positionnement de ladite au moins une photopile (1) et à l'exception de la ou des zones dudit support plan (6) au niveau de laquelle ou desquelles aboutissent les extrémités (4', 5') desdites pistes conductrices (4, 5),
la couche plane de protection (8) étant aménagée pour venir recouvrir lesdites pistes conductrices (4, 5) sur une zone de recouvrement, à l'exception desdites extrémités (4', 5') des pistes conductrices (4, 5).

2. Procédé selon la revendication 1, **caractérisé en ce qu'**il consiste à déposer un produit protecteur isolant sur les pistes conductrices (4, 5) du support plan (6), entre leurs deux extrémités, avant de fixer la ou les photopiles (1), puis la couche plane de protection (8).

3. Procédé selon la revendication 1 ou 2, **caractérisé en ce qu'**il consiste à dimensionner la dite couche plane de protection (8) d'épaisseur identique ou légèrement supérieure à l'épaisseur de la photopile (1), et à déposer un revêtement adhésif (10) sur sa surface supérieure permettant la fixation sur un support de réception transparent.

4. Procédé selon l'une quelconque des revendications 1 à 3, **caractérisé en ce qu'**il consiste à déposer un revêtement adhésif sur la face inférieure de ladite couche plane de protection (8) permettant sa fixation sur le support plan (6).

5. Procédé selon l'une quelconque des revendications 1 à 4, **caractérisé en ce qu'**il consiste à déposer un revêtement adhésif sur une face inférieure (11) du support plan (6) permettant la fixation sur un support de réception quelconque.

6. Procédé selon l'une quelconque des revendications 1 à 5, **caractérisé en ce qu'**il consiste à fournir ledit support plan (6) et ladite couche plane de protection (8) en matériau souple.

7. Procédé selon l'une quelconque des revendications 1 à 5, **caractérisé en ce qu'**il consiste à fournir ledit support plan (6) en matériau rigide, genre matière plastique ou résine, et ladite couche plane de protection (8) en matériau souple, par exemple en mousse synthétique.

8. Procédé selon l'une quelconque des revendications 1 à 7, **caractérisé en ce qu'**il consiste à constituer une zone de connectique (7) au moyen desdites pistes conductrices (4, 5) aboutissant à proximité les unes des autres au niveau de la bordure périphérique du support plan (6).

9. Procédé selon l'une quelconque des revendications 1 à 8, **caractérisé en ce qu'**il consiste à séparer lesdites pistes conductrices (4, 5) de la couche plane protectrice (8) par un produit isolant.

## Claims

1. A method of making a brightness sensor comprising at least one photovoltaic cell (1), the upper surface of which constitutes the brightness detection surface and the lower surface of which comprises two polarized outputs (2, 3) intended to be connected to a processing module of the signal for the automatic control of the functioning of an apparatus, the method consisting in;
providing the strip conductors (4, 5) on the upper surface of the planar support (6),
fixing the lower surface of said at least one photovoltaic cell (1) on the upper surface of the planar support (6) which is dimensional to overlap the entire periphery of said at least one photovoltaic cell (1), its polarized outputs (2,3,) coming into superposed contact with one of the ends of said strip conductors (4,5),
the two other ends (4', 5') of said strip conductors (4, 5) extending up to the pheripheral edge of said planar support (6), or substantially up to this peripheral edge,
**characterized in that** the method consists in fixing a planar protective layer (8) over said planar support (6), on the photovoltaic cell side (1), except for the positioning zone (13) of said at least one photovoltaic cell (1) and except for the zone or zones of said planar support (6) at the level of which the ends (4', 5') of said strip conductors (4, 5) terminate,
the planar protective layer (8) being dimensioned to cover said strip conductors (4, 5) over the covering zone, except for said ends (4', 5') of the strip conductors (4, 5).

2. The method according to claim 1, **characterized in that** it consists in depositing an insulating protective product on the strip conductors (4, 5) of the planar support (6), between both of their ends, before fixing the at least one photovoltaic cell (1) and then the planar protective layer (8).

3. The method according to any of claims 1 or 2, **characterized in that** it consists in dimensioning said planar protective layer (8) with a thickness identical to or slightly greater than the thickness of the photovoltaic cell (1), and in depositing an adhesive coating (10) on its upper surface allowing fixing on a transparent receiving support.

4. The method according to any claims 1 or 3, **characterized in that** it consists in depositing an adhesive coating on the lower surface of said planar protective layer (8) allowing its fixing on the planar support (6).

5. The method according to any of claims 1 to 4, **characterized in that** it consists in depositing an adhesive coating on the lower surface (11) of the planar support (6) allowing fixing on any receiving support.

6. The method according to any of claims 1 to 5, **characterized in that** (6) and said planar protective layer (8) in a flexible material.

7. The method according to any of claims 1 to 5, **characterized in that** it consists in providing said planar support (6) in a rigid material, of the plastic or resin material type, and said planar protective layer (8) in a flexible material, for example of synthetic foam.

8. A method according to any of claims 1 to 7, **characterized in that** it consists in constituting a connection zone (7) by means of said strip conductors (4, 5) terminating close to each other at the level of the peripheral edge of the planar support (6).

9. The method according to any of claims 1 to 8, **characterized in that** it consists in separating said strip conductors (4, 5) from the planar protective layer (8) by an insulating product.

## Patentansprüche

1. Verfahren zur Herstellung eines Helligkeitssensors, umfassend mindestens eine Fotozelle (1), deren Oberseite die Helligkeitserfassungsseite bildet und deren Unterseite zwei polarisierte Ausgänge (2, 3) umfasst, die dazu gedacht sind, an ein Signalverarbeitungsmodul angeschlossen zu werden für die automatische Steuerung des Betriebs einer Einrichtung, wobei das Verfahren folgende Schritte umfasst:
- Einrichten der Leiterbahnen (4, 5) auf der oberen Oberfläche des ebenen Trägers (6),
- Fixieren der Unterseite der mindestens einen Fotozelle (1) auf der Oberseite eines ebenen Trägers (6), der bemessen ist, um auf dem gesamten Umfang der mindestens einen Fotozelle (1) überzustehen, wobei seine bzw. ihre polarisierten Ausgänge (2, 3) in überlagertem Kontakt mit einem der Enden der Leiterbahnen (4, 5) angeordnet sind,
wobei die beiden anderen Enden (4', 5') der Leiterbahnen (4, 5) sich bis zur Umfangsumrandung des ebenen Trägers (6) oder im Wesentlichen bis zu dieser Umfangsumrandung erstrecken,
**dadurch gekennzeichnet, dass** das Verfahren darin besteht, eine ebene Schutzschicht (8) auf dem ebenen Träger (6) zu fixieren, auf Seiten der Fotozelle (1), mit Ausnahme des Bereichs (13) zum Positionieren der mindestens einen Fotozelle (1) und mit Ausnahme des Bereichs bzw. der Bereiche des ebenen Trägers (6) an dem bzw. denen die Enden (4', 5') der Leiterbahnen (4, 5) auskommen,
wobei die ebene Schutzschicht (8) eingerichtet ist, um die Leiterbahnen (4, 5) auf einem Überdeckungsbereich zu überdecken, mit Ausnahme der Enden (4', 5') der Leiterbahnen (4, 5).

2. Verfahren nach Anspruch 1, **dadurch gekennzeichnet, dass** es darin besteht, ein isolierendes Schutzmittel auf die Leiterbahnen (4, 5) des ebenen Trägers (6) zwischen ihren beiden Enden abzusetzen, bevor die Fotozelle(n) (1) und dann die ebene Schutzschicht (8) fixiert werden.

3. Verfahren nach Anspruch 1 oder 2, **dadurch gekennzeichnet, dass** es darin besteht, die ebene Schutzschicht (8) mit einer Dicke zu bemessen, die mit der Dicke der Fotozelle (1) identisch oder geringfügig größer ist, und eine Klebebeschichtung (10) auf ihre obere Oberfläche abzusetzen, welche die Fixierung auf einem durchsichtigen Aufnahmeträger ermöglicht.

4. Verfahren nach einem der Ansprüche 1 bis 3, **dadurch gekennzeichnet, dass** es darin besteht, eine Klebebeschichtung auf der Unterseite der ebenen Schutzschicht (8) abzusetzen, die ihre Fixierung auf dem ebenen Träger (6) ermöglicht.

5. Verfahren nach einem der Ansprüche 1 bis 4, **dadurch gekennzeichnet, dass** es darin besteht, eine Klebebeschichtung auf einer Unterseite (11) des ebenen Trägers (6) abzusetzen, welche die Fixierung auf einem beliebigen Aufnahmeträger ermöglicht.

6. Verfahren nach einem der Ansprüche 1 bis 5, **dadurch gekennzeichnet, dass** es darin besteht, den ebenen Träger (6) und die ebene Schutzschicht (8) aus einem biegsamen Material bereitzustellen.

7. Verfahren nach einem der Ansprüche 1 bis 5, **dadurch gekennzeichnet, dass** es darin besteht, den ebenen Träger (6) aus einem steifen Material, wie etwa aus Kunststoff oder Harz, und die ebene Schutzschicht (8) aus einem biegsamen Material, z.B. aus Schaumstoff, bereitzustellen.

8. Verfahren nach einem der Ansprüche 1 bis 7, **dadurch gekennzeichnet, dass** es darin besteht, einen anschlusstechnischen Bereich (7) mittels der Leiterbahnen (4, 5), die nahe nebeneinander an der Umfangsumrandung des ebenen Trägers (6) auskommen, zu bilden.

9. Verfahren nach einem der Ansprüche 1 bis 8, **dadurch gekennzeichnet, dass** es darin besteht, die Leiterbahnen (4, 5) der ebenen Schutzschicht (8) durch ein isolierendes Mittel zu trennen.
